# EUROPEAN PATENT SPECIFICATION

(11) **EP 1 388 926 B1**
(45) Date of publication and mention of the grant of the patent: **27.04.2005**
(21) Application number: 02017604.6
(22) Date of filing: 05.08.2002
(51) Int. Cl.: H02M 1/08, H03F 3/345, H03F 3/50, H03K 19/0185

(54) **Level shift voltage generator**
Pegelschiebender Spannungsgenerator
Generateur de tension à décalage de niveau

(43) Date of publication of application: 11.02.2004
(73) Proprietor: MATSUSHITA ELECTRIC INDUSTRIAL CO., LTD., Kadoma-shi, Osaka 571-0050 (JP)
(72) Inventor: Mochizuki, Kouji, Machida-shi, Tokyo 194-0212 (JP); Katada, Tomoyuki, deceased (JP)
(74) Representative: Grünecker, Kinkeldey, Stockmair & Schwanhäusser Anwaltssozietät

(56) References cited:
- EP-A- 0 913 932

## Description

This invention relates to a level shift voltage generator which is applied to an analog interface circuit.

Generally, a circuit having an analog interface such as a modulating circuit, audio codec circuit, etc. used in a communication device includes a level shift voltage generator for matching the DC voltage level of an analog signal. A conventional level shift voltage generator will be explained below.

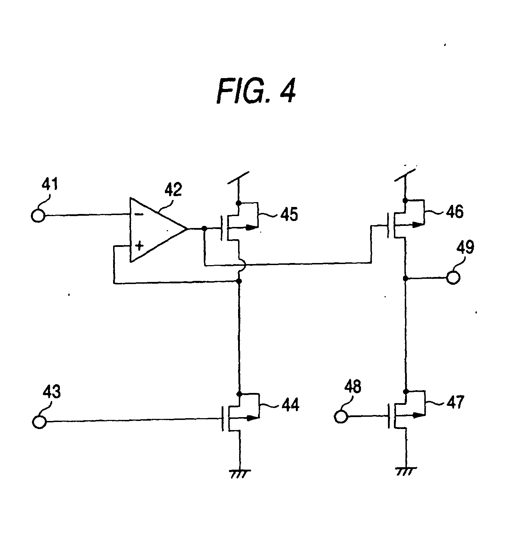

Fig. 4 is a circuit diagram showing the configuration of a conventional level shift voltage generator. In Fig. 4, reference numeral 41 denotes a first potential; 42 a second potential; 43 a second potential; 44 a first MOSFET; 45 a second MOSFET; 46 a third MOSFET having the same characteristic as that of the second MOSFET; 47 a fourth MOSFET having the same characteristic as that of the first MOSFET 44; 48 an input terminal; and 49 an output terminal.

An explanation will be given of the operation of the conventional level shift voltage generator having the configuration described above. The first potential 41 is supplied to an inverting input terminal of the operational amplifier 42, and the second potential 43 is supplied to a gate of the first MOSFET. A non-inverting input terminal of the operational amplifier 42 is connected to the source of the first MOSFET 44 and the drain of the second MOSFET 44. The output from the operational amplifier 42 is supplied to the gate of the second MOSFET 45. In this way, the current value of the second MOSFET 45 is controlled so that the source potential of the first MOSFET 44 is equal to the first potential 41.

In this case, since the output from the operational amplifier 42 is also connected to the gate of the third MOSFET 46, the current having the same direction and magnitude as the first MOSFET 44 and the second MOSFET 45 flows through the third MOSFET 46 and the fourth MOSFET 47. Therefore, the gate-source potential of the fourth MOSFET 47 becomes equal to that of the first MOSFET 44.

Thus, assuming that the gate of the fourth MOSFET47 is the input terminal 48 and the source thereof is the output terminal 49, the potential difference between the input terminal 48 and output terminal 49 is always equal to the gate-source potential, i.e. the potential difference between the first potential 41 and the second potential 42. Accordingly, the input analog potential can be easily level-shifted by any shift voltage.

However, in the configuration of the conventional level shift voltage generator, if the potential difference between the first potential and the second potential is smaller than the threshold voltage of a MOSFET, no current flows through the MOSFET so that the level shift voltage generator does not operate normally.

### SUMMARY OF THE INVENTION

This invention intends to solve the above problem to provide a level shift voltage generator which can operate normally even when the shift voltage is smaller than the threshold voltage of a MOSFET.

The level shift voltage generator of this invention comprises: an operational amplifier 12 with an inverting input terminal to which a first potential is inputted; a first MOSFET 15 with a gate connected to an output terminal of the operational amplifier and a drain connected to a non-inverting terminal thereof; a first resistor 14 connected between the drain of the first MOSFET and a second potential; a second MOSFETFET 16 with a gate connected to the gate of the first MOSFET 15; an output buffer 20 connected to a drain of said second MOSFET 16; and a second resistor 17 connected between the drain of the second MOSFET 16 and an input terminal 18.

In accordance with the level shift voltage generator, an input analog potential can be easily level-shifted by any shift voltage. Further, since a level shift voltage is created using a resistor, the shift voltage does not suffer the limitation such as the threshold voltage of the MOSFET, and hence a very small potential difference can be level-shifted accurately.

Preferably, the level shift voltage generator further comprises a capacitor 27c between the drain of the second MOSFET 26 and a third potential 27b in the level shift voltage generator.

In accordance with the level shift voltage generator, since a level shift voltage is created using a resistor which is a linear passive element, with the aid of a capacitor provided between the output terminal and third potential, a very small potential difference can be level-shifted accurately and a level shift voltage generator having a function of filtering can be easily obtained.

Further, the level shift voltage generator includes a current output terminal (analog output terminal 38g) of a current additive type digital-to-analog converter (current additive type DA converter 38) which is connected to the input terminal in the level shift voltage generator.

In accordance with the level shift voltage generator, since the level shift voltage is determined by only the resistance of the resistor and the value of the current flowing through the resistor, the current additive type DA converter which can be generally connected to only a circuit with a high input impedance can produce an accurate level shift voltage output as long as it is directly connected to the level shift voltage generator according to this invention. This simplifies the system inclusive of the current additive type DA converter and realizes the high speed of the circuit due to its reduced impedance.

### BRIEF DESCRIPTION OF THE DRAWINGS

Fig. 1 is a circuit diagram showing the configuration of a level shift voltage generator according to an embodiment of this invention;
Fig. 2 is a circuit diagram showing the configuration of a level shift voltage generator according to another embodiment of this invention;
Fig. 3 is a circuit diagram of a configuration in which the level shift voltage generator according to this invention is connected to an output terminal of a current additive type DA converter; and
Fig. 4 is a circuit diagram showing the configuration of a conventional level shift voltage generator.

### DETAILED DESCRIPTION OF THE PREFERRED EMBODIMENTS

### First Embodiment

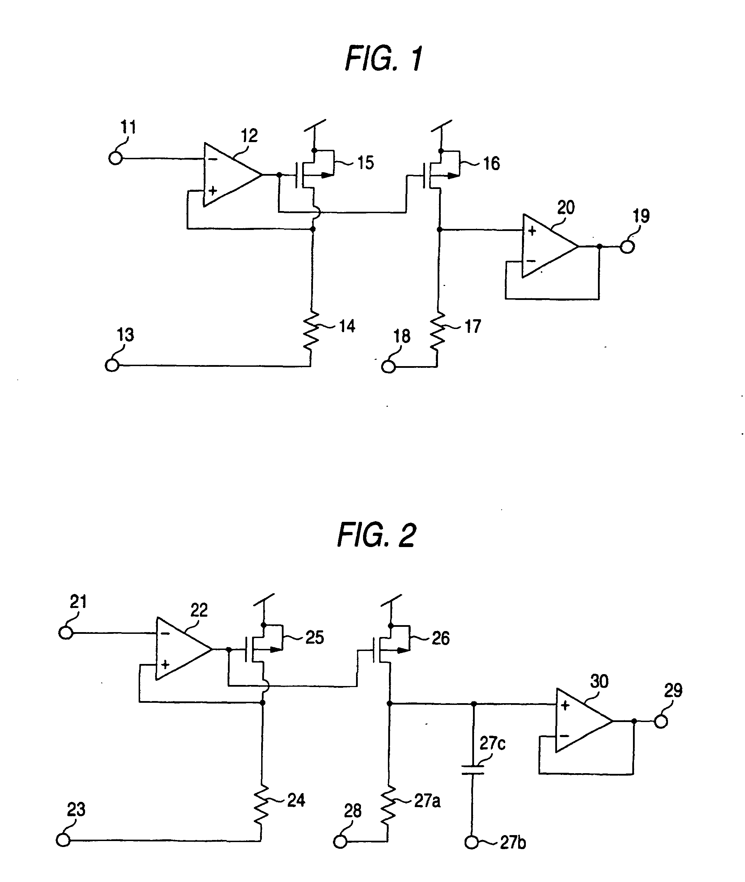

Now referring to the drawings, an explanation will be given of embodiments of this invention. Fig. 1 is a circuit diagram showing the level shift voltage generator according to a first embodiment of this invention. In Fig. 1, reference numeral 11 denotes a first potential; 12 an operational amplifier;13 a second potential; 14 a first resistor; 15 a first MOSFET; 16 a second MOSFET having the same characteristic as that of the first MOSFET 15; 17 a second resistor having a resistance equal to that of the first resistor 14; 18 an input terminal; 19 an output terminal; and 20 an output buffer.

An explanation will be given of the operation of the level shift voltage generator shown in Fig. 1 constructed as described above. The first potential 11 is supplied to the inverting input terminal of the operational amplifier 12 and the second potential 13 is supplied to the one terminal of the first resistor 14. The non-inverting input terminal of the operational amplifier 12 is connected to the other terminal of the resistor 14 and the drain of the first MOSFET 15. The output from the operational amplifier 12 is supplied to the gate of the first MOSFET 15. In this way, the current value of the first MOSFET 15 is controlled so that the potential difference across the first resistor 14 is equal to that between the first potential 11 and second potential 13.

In this case, since the output from the operational amplifier 12 is also supplied to the gate of the second MOSFET 16, the current having the same direction and magnitude as the first MOSFET 15 flows through the second MOSFET 16. Therefore, the potential difference across the second resistor 17 becomes equal to that across the first resistor 14.

Thus, assuming that the one terminal of the second resistor 17 is the input terminal 18 and the other terminal thereof is an input of the output buffer 20, the potential difference between the input terminal 18 and output terminal 19 is always equal to the potential difference between the first potential 11 and the second potential 13. Accordingly, the input analog potential can be easily level-shifted by any shift voltage. Further, since a level shift voltage is created using a resistor, the shift voltage does not suffer the limitation such as the threshold voltage of the MOSFET, and hence a very small potential difference can be level-shifted accurately

As described above, in accordance with this embodiment, a level shift voltage generator can be easily provided in which a small potential can be level-shifted accurately. Further, since a level shift voltage is created using a resistor which is a linear passive element, various circuit applications can be realized.

### Second Embodiment

Fig. 2 is a circuit diagram of a level shift voltage generator according to another embodiment of this invention. In Fig. 2, reference numeral 21 denotes a first potential; 22 an operational amplifier; 23 a second potential; 24 a first resistor; 25 a first MOSFET; 26 a second MOSFET having the same characteristic as that of the first MOSFET 25; 27a a second resistor having a resistance equal to that of the first resistor 24; 27b a third potential; 27c a capacitor; 28 an input terminal; 29 an output terminal; and 30 an output buffer.

An explanation will be given of the operation of the level shift voltage generator shown in Fig. 2 constructed as described above. The first potential 21 is supplied to the inverting input terminal of the operational amplifier 22 and the second potential 23 is supplied to the one terminal of the first resistor 24. The non-inverting input terminal of the operational amplifier 22 is connected to the other terminal of the resistor 24 and the drain of the first MOSFET 25. The output from the operational amplifier 22 is supplied to the gate of the first MOSFET 25. In this way, the current value of the first MOSFET 25 is controlled so that the potential difference across the first resistor 24 is equal to that between the first potential 21 and second potential 23.

In this case, since the output from the operational amplifier 22 is also supplied to the gate of the second MOSFET 26, the current having the same direction and magnitude as the first MOSFET 25 flows through the second MOSFET 26. Therefore, the potential difference across the second resistor 27a becomes equal to that across the first resistor 24.

Thus, assuming that the one terminal of the second resistor 27a is the input terminal 28 and the other terminal thereof is an input of the output buffer 30, the potential difference between the input terminal 28 and output terminal 29 is always equal to the potential difference between the first potential 21 and the second potential 23. Accordingly, the input analog potential can be easily level-shifted by any shift voltage.

The capacitor 27c connected between the second resistor 27a and the third potential 27b constitutes a first-order low pass filter together with the resistor 27a. For this reason, a small analog potential with a small potential difference can be level-shifted, and the function of filtering can be realized by slight addition of circuitry.

As described above, in accordance with this embodiment, a level shift voltage generator is provided in which can accurately level-shift a small potential difference accurately and also has a function of filtering.

### Third Embodiment

Further, in this embodiment, since the level shift voltage is determined by only the resistance of the resistor and the value of the current flowing through the resistor, the current additive type DA converter which can be generally connected to only a circuit with a high input impedance can produce an accurate level shift voltage output as long as it is directly connected to the level shift voltage generator according to this invention. This simplifies the system inclusive of a current additive type digital-to-analog (DA) converter and easily realizes reduced impedance which is indispensable to the high speed of the circuit.

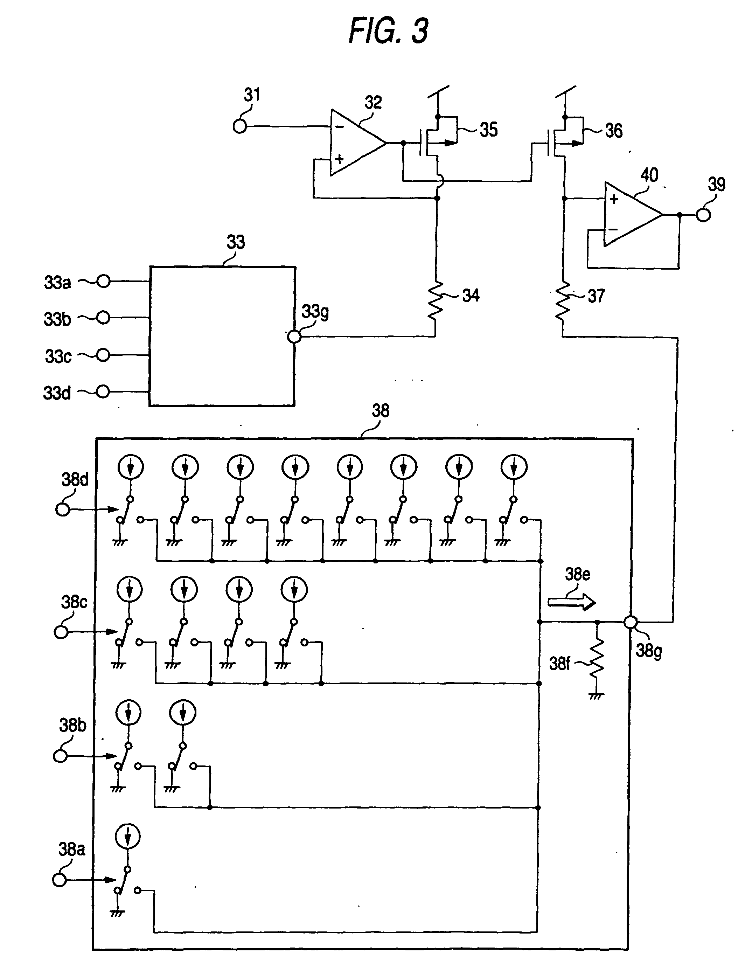

Fig. 3 is a circuit diagram showing the configuration in which the level shift voltage device according to this invention is connected to an analog output terminal of a current additive type digital-to-analog (DA) converter. In Fig. 3, reference numeral 31 denotes a first potential; 32 an operational amplifier; 33 a current additive type digital-to-analog (DA) converter as a second potential; 34 a first resistor; 35 a first MOSFET; 36 a second MOSFET having the same characteristic as that of the first MOSFET; 37 a second resistor having a resistance equal to that of the first resistor 34; 38 a current additive type digital-to-analog (DA) converter; and 39 an output terminal.

In the current additive type DA converter 38, reference numeral 38a denotes a digital input terminal to which the LSB of an digital input for the current additive type DA converter 38 is supplied; 38b a digital input terminal to which the second bit of the digital input for the current additive type DA converter 38 is supplied; 38c a digital input terminal to which the third bit of the digital input for the current additive type DA converter 38 is supplied; 38d a digital input terminal to which the MSB of the digital input for the current additive type DA converter 38 is supplied; 38e an output current from the current additive type converter 38; 38f an output load resistor of the current additive type DA converter; 38g an analog output terminal from which an analog output from the current additive type DA converter 38 is outputted. The current additive type DA converter 33 has a same configuration.

An explanation will be given of the operation of the level shift voltage generator shown in Fig. 3 constructed as described above. The first potential 31 is supplied to the inverting input terminal of the operational amplifier 32 and the second potential output from the current additive type digital-to-analog (DA) converter 33 is supplied to the one terminal of the first resistor 34. The non-inverting input terminal of the operational amplifier 32 is connected to the other terminal of the resistor 34 and the drain of the first MOSFET 35. The output from the operational amplifier 32 is supplied to the gate of the first MOSFET 35. In this way, the current value of the first MOSFET 35 is controlled so that the potential difference across the first resistor 34 is equal to that between the first potential 31 and second potential 33g.

In this case, since the output from the operational amplifier 32 is also supplied to the gate of the second MOSFET 36, the current having the same direction and magnitude as the first MOSFET 35 flows through the second MOSFET 36. Namely, the current flowing through the second MOSFET 36 can be easily set using the first potential and second potential.

Further, the current additive type DA converter 38 supplies, to the output load resistor 38f, the output current 38e corresponding to the four bit digital inputs inputted to the digital input terminals 38a, 38b, 38c and 38d. Through the output load resistor 38f, a current equal to the sum of the output current 38e and the current passing the second MOSFET 36 flows. From the analog output terminal 38g, a total voltage of an inherent voltage output and the DC offset due to the current flowing through the second MOSFET 36 is outputted.

Thus, assuming that the one terminal of the second resistor 37 is the analog output terminal 38g of the current additive type DA converter 38 and the other terminal thereof is an input of the output buffer 40 of the level shift voltage generator, the potential difference between the analog output terminal 38g and output terminal 39 can be optionally set by the first potential 31 and the second potential 33. Accordingly, the input analog potential can be easily level-shifted by any shift voltage.

In this case, only the second resistor 37 and the output load resistor 38f of the current additive type DA converter 38 are connected to the analog output terminal 38g of the current additive type DA converter 38. In addition, the drain of the second MOSFET 38f and the second resistor 37 are connected to the output terminal 39 of the level shift voltage generator. For this reason, the output impedance can be set for a low value, thereby easily realizing the high speed of the circuit and simplification thereof.

As described above, in accordance with this embodiment, the output from the current additive type DA converter can be level-shifted, and the DA converter and level shift voltage generator which can implement the high speed and simplification of the circuit can easily provided.

As described hitherto, in accordance with this invention, an input analog potential can be easily level-shifted by any shift voltage. Further, by creating a level shift voltage using a resistor, the shift voltage does not suffer the limitation such as the threshold voltage of the MOSFET, and hence a very small potential difference can be level-shifted accurately.

Further, in accordance with this invention, by providing a capacitor between the output terminal and third potential, a level shift voltage generator having a function of filtering can be easily obtained.

Further, in accordance with this invention, the current additive type DA converter which generally requires the high impedance of a load can produce an accurate level shift voltage output as long as it is directly connected to the level shift voltage generator according to this invention. This simplifies the system inclusive of the current additive type DA converter and realizes the high speed of the circuit due to its reduced impedance.

## Claims

1. A level shift voltage generator comprising
an operational amplifier (12,22,32) with an inverting input terminal to which a first potential (11; 21; 31) is inputted;
a first MOSFET (15; 25; 35) with a gate connected to an output terminal of said operational amplifier (12,22,32) and a drain connected to a non-inverting terminal thereof;
a second MOSFET (16; 26; 36) with the gate connected to the gate of said first MOSFET (15; 23; 35);
**characterized by**:
a first resistor (14; 24; 34) connected between the drain of said first MOSFET (15; 25; 35) and a second potential (13; 23; 33g);
an output buffer (20; 30; 40) connected to the drain of said second MOSFET (16;26; 36); and
a second resistor (17; 27a; 37) connected between the drain of said second MOSFET (16; 26; 36) and an input terminal (18; 28; 38g).

2. A level shift voltage generator according to claim 1, further comprising a capacitor (27c) between the drain of said second MOSFET (26) and a third potential (27b).

3. A level shift voltage generator according to claim 1 or 2, further comprising a current output terminal of a current additive type digital-to-analog (DA) converter (38) which is connected to said input terminal (38g).

4. A level shift voltage generator according to claim 1 or 2, further comprising a current output terminal (33g) of a current additive type digital-to-analog (DA) converter (33) which is connected to said first resistor (34) as the second potential.

## Patentansprüche

1. Pegelschiebender Spannungsgenerator, umfassend:
- einen Operationsverstärker (12, 22, 32) mit einem invertierenden Eingangsanschluss, in den ein erstes Potenzial (11, 21, 31) eingegeben wird;
- einen ersten MOS-Feldeffekttransistor (15, 25, 35), wobei ein Gate mit einem Ausgangsanschluss des Operationsverstärkers (12, 22, 32) verbunden ist und ein Drain mit einem nicht invertierenden Anschluss davon verbunden ist;
- einen zweiten MOS-Feldeffekttransistor (16, 26, 36), wobei das Gate mit dem Gate des ersten MOS-Feldeffekttransistors (15, 23, 35) verbunden ist;
**gekennzeichnet durch**:
- einen ersten Widerstand (14, 24, 34), der zwischen dem Drain des ersten MOS-Feldeffekttransistors (15, 25, 35) und einem zweiten Potenzial (13, 23, 33g) geschaltet ist;
- einen Ausgangspuffer (20, 30, 40), der mit dem Drain des zweiten MOS-Feldeffekttransistors (16, 26, 36) verbunden ist; und
- einen zweiten Widerstand (17, 27a, 37), der zwischen dem Drain des zweiten MOS-Feldeffekttransistors (16, 26, 36) und einem Eingangsanschluss (18, 28, 38g) geschaltet ist.

2. Pegelschiebender Spannungsgenerator nach Anspruch 1, des Weiteren einen Kondensator (27c) zwischen dem Drain des zweiten MOS-Feldeffekttransistors (26) und einem dritten Potenzial (27b) umfassend.

3. Pegelschiebender Spannungsgenerator nach Anspruch 1 oder 2, des Weiteren einen Stromabgabeanschluss eines Strom zuführenden Digital/Analog-Wandlers (D/A-Wandler) (38) umfassend, der mit dem Eingangsanschluss (38g) verbunden ist.

4. Pegelschiebender Spannungsgenerator nach Anspruch 1 oder 2, des Weiteren einen Stromabgabeanschluss (33g) eines Strom zuführenden Digital/Analog-Wandlers (D/A-Wandler) (33) umfassend, der mit dem ersten Widerstand (34) als zweites Potenzial verbunden ist.

## Revendications

1. Générateur de tension à décalage de niveau comprenant
un amplificateur opérationnel (12, 22, 32) avec une borne d'entrée inverseuse sur laquelle un premier potentiel (11 ; 21 ; 31) est entré ;
un premier transistor MOFSET (15 ; 25 ; 35) avec une grille reliée à une borne de sortie dudit amplificateur opérationnel (12, 22, 32) et un drain relié à sa borne d'entrée non inverseuse ;
un second transistor MOFSET (16 ; 26 ; 36) avec la grille reliée à la grille du premier transistor MOFSET (15 ; 23 ; 35) ;
**caractérisé par** :
une première résistance (14 ; 24 ; 34) reliée entre le drain dudit premier transistor MOFSET (15 ; 25 ; 35) et une second potentiel (13 ; 23 ; 33g) ;
un amplificateur séparateur de sortie (20 ; 30 ; 40) relié au drain du second transistor MOFSET (16 ; 26 ; 36) ; et
une seconde résistance (17 ; 27a ; 37) reliée entre le drain dudit second transistor MOFSET (16 ; 26 ; 36) et une borne d'entrée (18 ; 28 ; 38g).

2. Générateur de tension à décalage de niveau selon la revendication 1, comprenant, en outre, un condensateur (27c) entre le drain dudit second transistor MOFSET (26) et un troisième potentiel (27b).

3. Générateur de tension à décalage de niveau selon la revendication 1 ou 2, comprenant, en outre, une borne de sortie de courant d'un convertisseur numérique/analogique du type à courant additif (N/A) (38) qui est reliée à ladite borne d'entrée (38g).

4. Générateur de tension à décalage de niveau selon la revendication 1 ou 2, comprenant, en outre, une borne de sortie de courant (33g) d'un convertisseur numérique/analogique du type à courant additif (N/A) (33) qui est relié à ladite première résistance (34) comme le second potentiel.
